# EUROPEAN PATENT APPLICATION

(11) **EP 2 416 369 A1**
(43) Date of publication of application: **08.02.2012**
(21) Application number: 11176279.5
(22) Date of filing: 02.08.2011
(51) Int. Cl.: H01L 31/02, H01L 31/048, H01L 31/05

(54) **Photovoltaic panel wall**

(30) Priority: 02.08.2010 CN 201010244485
(71) Applicant: Tyco Electronics (Shanghai) Co., Ltd., Waigaoqiao Free Trade Zone Shanghai (CN)
(72) Inventor: Wang, Young, Shanghai (CN); Chen, Xiaoqun, Shanghai (CN); Zhou, Chunfu, Shanghai (CN); Hu, Lintao, Shanghai (CN); Zheng, Jianglong, Shanghai (CN)
(74) Representative: Grünecker, Kinkeldey, Stockmair & Schwanhäusser

(57) **Abstract**

The present invention discloses a photovoltaic panel wall mounted on a building frame and comprising at least two photovoltaic assembly units. Each of the at least two photovoltaic assembly units comprises an electrical connector having a male terminal and a female terminal that are configured to be detachably engaged. Any adjacent two of the at least two photovoltaic assembly units are electrically connected by use of the respective electrical connectors thereof. An opening is formed in the building frame, and one of the male and female terminals of the electrical connector is fixed in the opening.

## Description

### CROSS-REFERENCE TO RELATED APPLICATION

This application claims the benefit of Chinese Patent Application No. 201010244485.0 filed on August 2, 2010 in the State Intellectual Property Office of China, the whole disclosure of which is incorporated herein by reference.

### BACKGROUND OF THE INVENTION

### Field of the Invention

The present invention relates to a Building Integrated Photovoltaic (BIPV) technology, more particularly, relates to a photovoltaic panel wall mounted on a building frame.

### Description of the Related Art

With the development of the photovoltaic industry, the Building Integrated Photovoltaic technology applied to various solar products on the building has been proposed as, for example, photovoltaic panel wall mounted on the building frame.

The photovoltaic panel wall is mounted on the building frame and constitutes a part of the wall of the building. Because modern buildings are often tall and great, it is very difficult for an operator to assemble the large photovoltaic panel wall on the tall and great buildings with high accuracy. Generally, in consideration of facilitating the installation operation and improving the installation accuracy, the photovoltaic panel wall consists of a plurality of small photovoltaic assembly units that can be removably assembled on the building frame. Accordingly, the operator can assemble only one small photovoltaic assembly unit on the building frame each time, instead of assembling the whole large photovoltaic panel wall on the building frame one time. In addition, after being mounted on the building frame, the plurality of small photovoltaic assembly units need to be electrically connected with each other to constitute a whole photovoltaic panel wall or a complete photovoltaic system.

Unfortunately, so far, inventors of the present application have not found a suitable solution to achieve a simple and quick electrical connection between the photovoltaic assembly units in the prior arts.

### SUMMARY OF THE INVENTION

The present invention has been made to overcome or alleviate at least one aspect of the above mentioned disadvantages.

Accordingly, it would be desirable to provide a photovoltaic panel wall which can achieve a simple and quick electrical connection between the photovoltaic assembly units.

According to an aspect of the present invention, there is provided a photovoltaic panel wall mounted on a building frame and comprising at least two photovoltaic assembly units. Each of the at least two photovoltaic assembly units comprises an electrical connector having a male terminal and a female terminal that are configured to be detachably engaged. Any adjacent two of the at least two photovoltaic assembly units are electrically connected by use of electrical connectors thereof. An opening is formed in the building frame, and one of the male and female terminals of the electrical connector is fixed in the opening.

In an embodiment according to the present invention, the one of the male and female terminals of the electrical connector is fixed in the opening by a screw.

In another embodiment according to the present invention, the one of the male and female terminals of the electrical connector is fixed in the opening by a snapper.

In another embodiment according to the present invention, each of the at least two photovoltaic assembly units further comprises at least one layer of photovoltaic glass.

In another embodiment according to the present invention, each of the at least two photovoltaic assembly units further comprises at least one layer of normal glass, and the at least one layer of photovoltaic glass is located at outmost of the photovoltaic panel wall.

In another embodiment according to the present invention, the at least one layer of photovoltaic glass and the at least one layer of normal glass both are removably assembled on the building frame.

In various embodiments of the present invention, by forming the opening in the building frame and fixing one of the male and female terminals of the electrical connector in the opening, the other of the male and female terminal of the electrical connector can be simply inserted into the one terminal. In this way, a plurality of photovoltaic assembly units can be simply and quickly electrically connected together or detached from each other.

### BRIEF DESCRIPTION OF THE DRAWINGS

Fig.1 shows a part of a photovoltaic panel wall according to an embodiment of the present invention; and
Fig.2 shows an electrical connector of a photovoltaic assembly unit mounted on the building frame according to an embodiment of the present invention.

### DETAILED DESCRIPTION OF PREFERRED EMBODIMENTS OF THE INVENTION

The embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

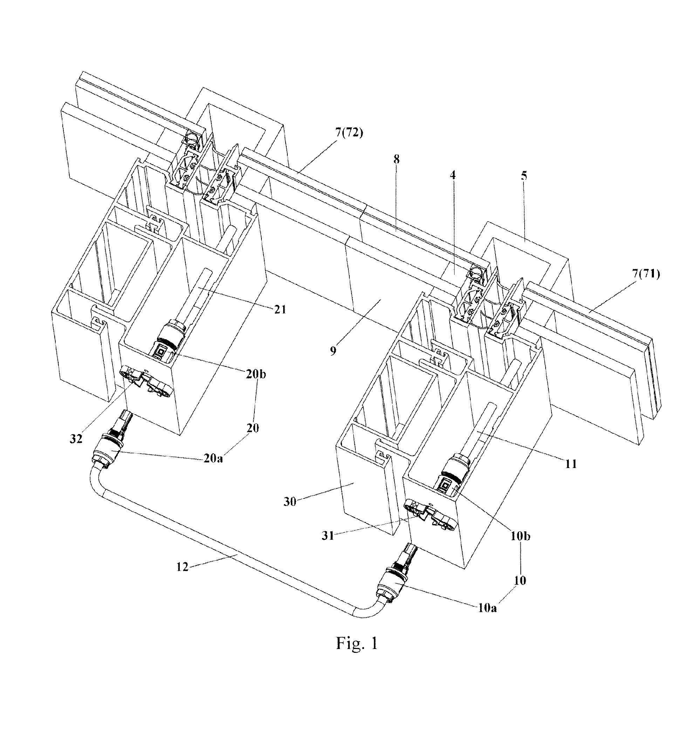

Fig.1 shows a part of a photovoltaic panel wall according to an embodiment of the present invention.

In an embodiment of the present invention, the photovoltaic panel wall may comprise two or more photovoltaic assembly units, although only two photovoltaic assembly units are shown in the embodiment of Fig.1.

As shown in Fig.1, the photovoltaic panel wall comprises a first photovoltaic assembly unit and a second photovoltaic assembly unit. The first photovoltaic assembly unit comprises a first electrical connector 10 and a first photovoltaic glass block 71. Similarly, the second photovoltaic assembly unit comprises a second electrical connector 20 and a second photovoltaic glass block 72.

Referring to Fig.1, the first electrical connector 10 is electrically connected to the first photovoltaic glass block 71 via a first cable 11. Similarly, the second electrical connector 20 is electrically connected to the second photovoltaic glass block 72 via a second cable 21. The first electrical connector 10 is electrically connected to the second electrical connector 20 via a third cable 12. In this way, the first photovoltaic assembly unit is electrically connected with the second photovoltaic assembly unit.

Please refer to Fig.1 again, the first electrical connector 10 has a male terminal 10a electrically connected to the first cable 11 and a female terminal 10b electrically connected to one end of the third cable 12. The male terminal 10a and the female terminal 10b of the first electrical connector 10 are configured to be removably engaged with each other. Similarly, the second electrical connector 20 has a male terminal 20a electrically connected to the second cable 21 and a female terminal 20b electrically connected to the other end of the third cable 12. The male terminal 20a and the female terminal 20b of the second electrical connector 20 are configured to be removably engaged with each other.

For the convenience of manufacture and assemble, in an embodiment of the present invention, all photovoltaic assembly units constituting the photovoltaic panel wall have an exactly same structure. But, the present invention is not limited to this, photovoltaic assembly units may have different structures.

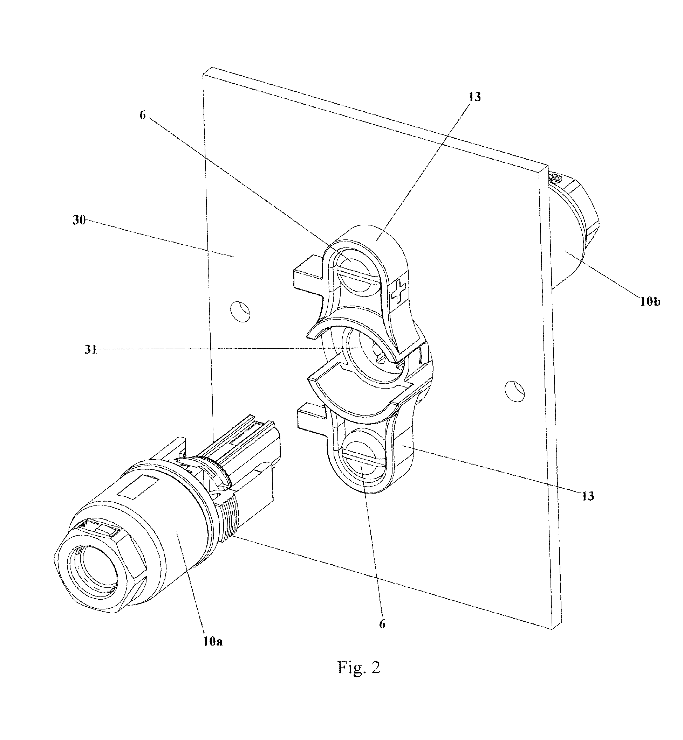

Fig.2 shows the first electrical connector 10 of the first photovoltaic assembly unit mounted on the building frame 30 according to an embodiment of the present invention.

As shown in Fig.1 and Fig.2, an opening 31 is formed in the building frame 30, the female terminals 10b of the first electrical connector 10 is inserted into the opening 31 and is secured on the building frame 30 so as to fix the female terminals 10b in the opening 31. In this embodiment of the present invention, because the female terminals 10b of the first electrical connector 10 is fixed and can not move, the male terminal 10a of the first electrical connector 10 can be easily aimed at the female terminals 10b and inserted into or pulled out of the female terminals 10b.

In the embodiment shown in Fig.2, the female terminal 10b is fixed in the opening 31 of the building frame 30. But, please be noted that the terminal fixed in the opening 31 may be any one of the male terminal 10a and the female terminal 10b of the first electrical connector 10. For example, the male terminal 10a is fixed in the opening 31 and the female terminal 10b is not fixed.

Similarly, as shown in Fig.1, the another opening 32 is formed in the building frame 30, the female terminals 20b of the second electrical connector 20 is inserted into the opening 32 and is secured on the building frame 30 so as to fix the female terminals 20b in the opening 32.

In an embodiment of Fig.1, the openings 31 and 32 both are formed in the rear side wall of the building frame 30 facing the inner of the building. But the present invention is not limited to this, the openings 31 and 32 may be formed in other side wall of the building frame 30, such as the left side wall or the right side wall.

As shown in Fig.2, the female terminal 10b of the first electrical connector 10 has two wings 13, 13 extending from a periphery of the female terminal 10b. When the female terminal 10b is inserted into the opening 31 of the building frame 30, the two wings 13, 13 of the female terminal 10b are secured on the building frame 30 by, for example, screws 6. In this way, the female terminal 10b of the first electrical connector 10 is fixed in the opening 31.

Please be noted that the female terminal 10b of the first electrical connector 10 may be fixed in the opening 31 of the building frame 30 by other ways, such as snapping manner or adhering manner.

Referring to Fig.1 again, in an embodiment of the present invention, the photovoltaic panel wall totally comprises three layers from the outside to the inside. The first layer is a photovoltaic glass layer 7 located at outmost of the photovoltaic panel wall, and the second and third layers are two normal glass layers 8 and 9. In order to improve the sound and thermal insulation effect, the three glass layers 7, 8 and 9 may be arranged to form an air gap between two adjacent layers thereof.

Please be noted that the structure of the photovoltaic panel wall of the present invention is not limited to the embodiment shown in Fig.1, the photovoltaic panel wall may comprises two or more layers of photovoltaic glasses, or comprises one, three or more layers of normal glasses.

In the present invention, the term 'photovoltaic glass' means such a glass product that can collect the solar energy and convert the solar energy into the electrical energy. The photovoltaic glass of the present invention may adopt any one of commercially available photovoltaic glass products. For the concise, description of these commercially available photovoltaic glass products is omitted herein.

The whole photovoltaic glass layer 7 of the photovoltaic panel wall consists of photovoltaic glass blocks of the plurality of photovoltaic assembly units. As shown in Fig.1, in an embodiment, the photovoltaic glass layer 7 consists of the first photovoltaic glass block 71 of the first photovoltaic assembly unit and the second photovoltaic glass block 72 of the second photovoltaic assembly unit. Similarly, the normal glass layers 8, 9 each consists of normal glass blocks of the plurality of photovoltaic assembly units. Therefore, in order to prevent dust or dirt from entering into the building through the gap between the glass blocks, elastic seals 4, 5 are provided to seal the gap between the glass blocks. With this feature, it also can prevent the outer strong wind from blowing into the building and generating annoying noise.

As shown in Fig.1, the three layers of glasses 7, 8, 9 are sandwiched and held in the building frame 30. But the present invention is not limited to this, the three layers of glasses 7, 8, 9 may be adhered on the building frame 30.

Although several embodiments have been shown and described, it would be appreciated by those skilled in the art that various changes or modifications may be made in these embodiments without departing from the principles and spirit of the disclosure, the scope of which is defined in the claims and their equivalents. It should be noted that the term "comprising"' does not exclude other elements or steps and the "a" or "an" does not exclude a plurality. It should also be noted that reference signs in the claims shall not be construed as limiting the scope of the claims.

## Claims

1. A photovoltaic panel wall mounted on a building frame (30) comprising at least two photovoltaic assembly units,
each of the at least two photovoltaic assembly units comprises an electrical connector (10, 20) having a male terminal (10a) and a female terminal (10b) that are configured to be detachably engaged,
any adjacent two of the at least two photovoltaic assembly units are electrically connected by use of the respective electrical connectors (10, 20) thereof,
wherein an opening (31) is formed in the building frame (30), and one of the male and female terminals (10a, 10b) of the electrical connector (10) is fixed in the opening (31).

2. The photovoltaic panel wall according to claim 1, wherein the one of the male and female terminals (10a, 10b) of the electrical connector (10) is fixed in the opening (31) by a screw (6).

3. The photovoltaic panel wall according to claim 1, wherein the one of the male and female terminals (10a, 10b) of the electrical connector (10) is fixed in the opening (31) by a snapper.

4. The photovoltaic panel wall according to claim 1, wherein each of the at least two photovoltaic assembly units further comprises at least one layer of photovoltaic glass (7).

5. The photovoltaic panel wall according to claim 4, wherein each of the at least two photovoltaic assembly units further comprises at least one layer of normal glass (8, 9), and the at least one layer of photovoltaic glass (7) is located at outmost of the photovoltaic panel wall.

6. The photovoltaic panel wall according to claim 5, wherein the at least one layer of photovoltaic glass (7) and the at least one layer of normal glass (8, 9) both are removably assembled on the building frame (30).
